# EUROPEAN PATENT APPLICATION

(11) **EP 1 126 466 A1**
(43) Date of publication of application: **22.08.2001**
(21) Application number: 00830115.2
(22) Date of filing: 18.02.2000
(51) Int. Cl.: G11C 7/16, G06F 12/02, G06F 3/16

(54) **Electronic device for the recording/reproduction of voice data**

(71) Applicant: STMicroelectronics S.r.l., 20041 Agrate Brianza (Milano) (IT)
(72) Inventor: Borgatti, Michele, 41035 Finale Emilia (IT); Rocchi, Alessandro, 57013 Rosignano Solvay (IT); Bisio, Marco, 41100 Modena (IT); Rolandi, Pierluigi, 15059 Monleale (IT); Pasotti, Marco, 27028 S.Martino Siccomario (IT)
(74) Representative: Cerbaro, Elena, Dr.

(57) **Abstract**

The electronic device (1) is integrated in a chip (50) of semiconductor material, and comprises a control unit (3), a signal-conversion unit (4), and a non-volatile memory unit (5), which are connected together via a main transmission line (6). The signal-conversion unit (4) is designed to receive at input an analog signal correlated to a voice signal, and to generate at output a stream of appropriately compressed digital signals. The stream of compressed digital signals is then stored in pre-set memory locations of the non-volatile memory unit (5) according to the control signals generated by the control unit (3). During reproduction, the compressed digital signals stored in the non-volatile memory unit (5) are supplied to the signal-conversion unit (4), which decompresses them and sends them to a loudspeaker (43).

## Description

The present invention refers to an electronic device for the recording/reproduction of voice data. The electronic device according to the invention further enables editing of recorded voice messages.

As is known, electronic devices of a discrete type available on the market for the recording/reproduction of voice data coming from a user. In detail, these known devices convert the voice data into analog signals, which, in turn, are converted into a plurality of digital signals. The plurality of digital signals is then stored in a memory, for example of the DRAM type, from which it is subsequently fetched to be re-converted into the analog signal, which is sent to a loudspeaker for reproduction of the original voice message.

Also known are electronic devices of the integrated type for the recording/reproduction of voice data, which process directly the analog signal correlated to the voice message of the user, without converting it into the digital form. In particular, the analog signal is sampled at a pre-set sampling frequency, and the plurality of analog samples thus obtained is sequentially stored in an analog non-volatile memory. The plurality of analog samples is then sent to a loudspeaker for reproduction of the original voice message.

Both these known devices present, however, the drawback that they require an increasingly higher circuit complexity, and consequently involve increasingly higher costs, as the storage capacity required for data storage increases. What has been said is particularly true in the case of discrete-type devices, in which an increasingly higher circuit complexity results in an increase in costs which is even higher than in an integrated system. In addition, known devices of a discrete type which use DRAM memories have rather high consumption levels, in that they must remain turned on all the time to prevent complete loss of the data stored in the DRAM memory itself.

The technical problem that the present invention aims at solving is to provide an electronic device for the recording/reproduction of voice data that overcomes the limitations and drawbacks described above with reference to the known art.

The technical problem is solved by an electronic device as defined in Claim 1.

The characteristics and advantages of the electronic device according to the invention will emerge clearly from the ensuing description of an example of embodiment, which is given simply to provide a non-limiting illustration, with reference to the attached drawings, in which:
- Figure 1 is a block diagram of the electronic device for the recording/reproduction of voice data according to the invention; and
- Figures 2 and 3 present flow charts regarding operation of the device of Figure 1.

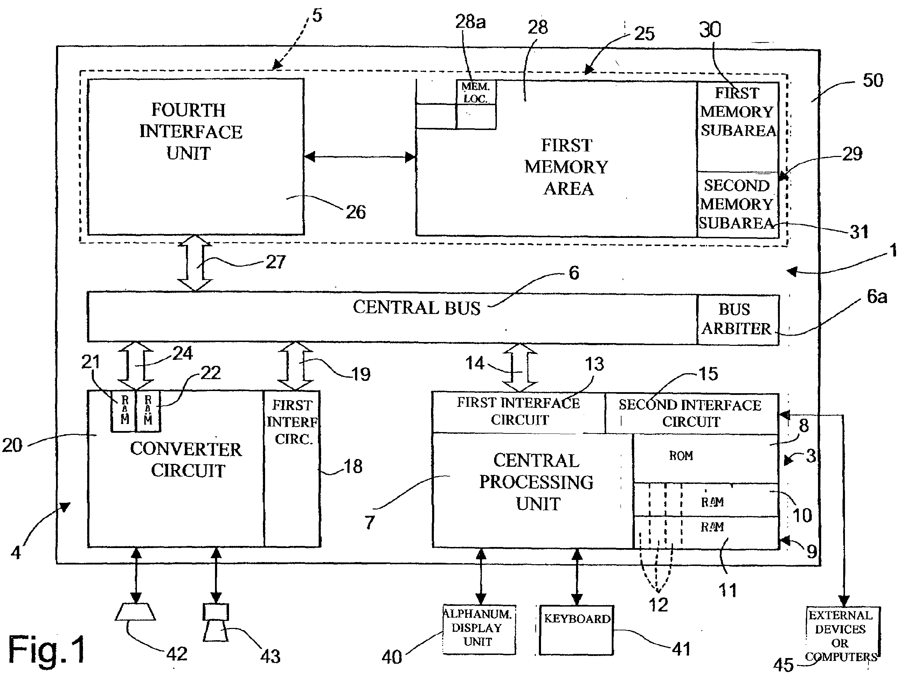

The electronic device 1 has the function of recording and reproducing voice data, and is also able to erase and edit voice data. The electronic device 1, shown in Figure 1, is integrated in a chip 50 of semiconductor material and comprises a control unit 3, implemented, for example, by means of a microprocessor or microcontroller, a signal-conversion unit 4, and a non-volatile memory unit 5. The units 3, 4 and 5 are connected together via a central bus 6, through which data and instructions are exchanged between the various units in the form of digital signals. The central bus 6 can also include a bus arbiter 6a which co-ordinates access of the units 3, 4, 5 to the central bus 6 so as to prevent any conflict between the said units. This structure of the electronic device 1 means that the implementation of each unit is independent of the others.

In greater detail, the control unit 3 includes a central processing unit (CPU) 7 which has logic, arithmetical and control functions; a read-only memory (ROM) 8, which is available upon turning-on of the electronic device 1 and in which data and instructions used by the CPU 7 for managing operation of the electronic device 1 are permanently stored; and a random-access memory (RAM) 9 for temporary reading and writing of data and instructions. In detail, the RAM memory 9 is divided into two memory banks 10, 11, each of which is in turn subdivided into a plurality of memory modules 12 that may be accessed individually. In particular, the memory modules 12 having lower addresses are designed for data storage, whilst the memory modules having higher addresses can be used for storage of programs for fetching instructions from the CPU 7, or can remain available for data storage.

The control unit 3 further comprises a first interface circuit 13, which co-ordinates exchange of data and instructions between the control unit 3 and the central bus 6, and is, for instance, implemented by means of a 16-bit direct-memory-access (DMA) circuit. The first interface circuit 13 is connected to the central bus 6 via a first local bus 14. The control unit 3 may also include a second interface circuit 15, of the serial type, which co-ordinates exchange of information and software between the control unit 3 itself and external devices or computers 45 for carrying out user applications.

The control unit 3 may moreover be connected to an alphanumeric display unit 40 and to a keyboard 41. By means of the latter, the user can supply to the electronic device 1 appropriate user commands via interrupt signals for selecting the desired function among those implemented by the device (recording, reproduction, erasure, editing).

Again with reference to Figure 1, the signal-conversion unit 4 comprises a third interface circuit 18 which co-ordinates exchange of data and instructions between the unit 4 itself and the central data bus 6, to which the third interface circuit 18 is connected via a second local data bus 19. The signal-conversion unit 4 further comprises a converter circuit 20, which implements a data compression/decompression algorithm with adaptive differential pulse-code modulation (ADPCM), known in the literature, and first and second RAM buffers 21, 22, which are connected to the central bus 6 via a third local bus 24. The signal-conversion unit 4 uses the first and second RAM buffers 21, 22 alternately for data storage, so as to reduce the time of use of the central bus 6 and the data transfer time, as will be explained in greater detail in what follows. The converter circuit 20, which is obtained, for example, by means of a wired digital circuit which implements an algorithm for digital compression of the voice signal or by means of a digital signal processor (DSP), has an input 20a connected to a microphone 42 and an output 20b connected to a loudspeaker 43. The input 20a is connected to the microphone 42 via an analog-to-digital converter and appropriate filters, whilst the output 20b is connected to the loudspeaker 43 via a digital-to-analog converter and appropriate filters. The converters and filters are not shown in Figure 1 because they are of a known type.

In addition, the non-volatile memory 5 comprises a memory device 25 made, for example, by means of a flash EEPROM digital memory of the multilevel type, embedded in the chip 50. The memory device 25 is connected to a fourth interface circuit 26, which co-ordinates exchange of data and instructions between the non-volatile memory unit 5 and the central bus 6, to which the fourth interface circuit 26 is connected via a fourth local data bus 27. This interface circuit 26 moreover provides synchronization between the speed of the memory device 25 and the speed of the central bus 26; in addition, it adapts the format of blocks or packets of data exchanged between the converter circuit 20 and the memory device 25 and implements a strategy of recovery of commands lost or failed.

As shown in Figure 1, the memory device 25 is schematically divided into two memory areas 28, 29. The first memory area 28 is made up of a plurality of memory locations 28a which are logically organized as a sequence of blocks having a pre-set dimension, for storage of the data coming from the signal-conversion unit 4, whilst the second memory area 29 comprises a first sub-area 30 and a second sub-area 31. In particular, in the first sub-area 30 is stored a list of addresses of the memory locations 28a that are free in the first memory area 28, whilst in the second sub-area 31 is stored a pointer list for storing the sequence in which the memory locations 28a of the first memory area 28 are to be read during reproduction.

The local buses 14, 19, 24 and 27 are hierarchically organized. In particular, the first local bus 14 and the third local bus 24 have a privileged access to the central bus 6 in that they guarantee connection with the CPU 7 and the converter circuit 20, which are of fundamental importance for the operation of the electronic device 1.

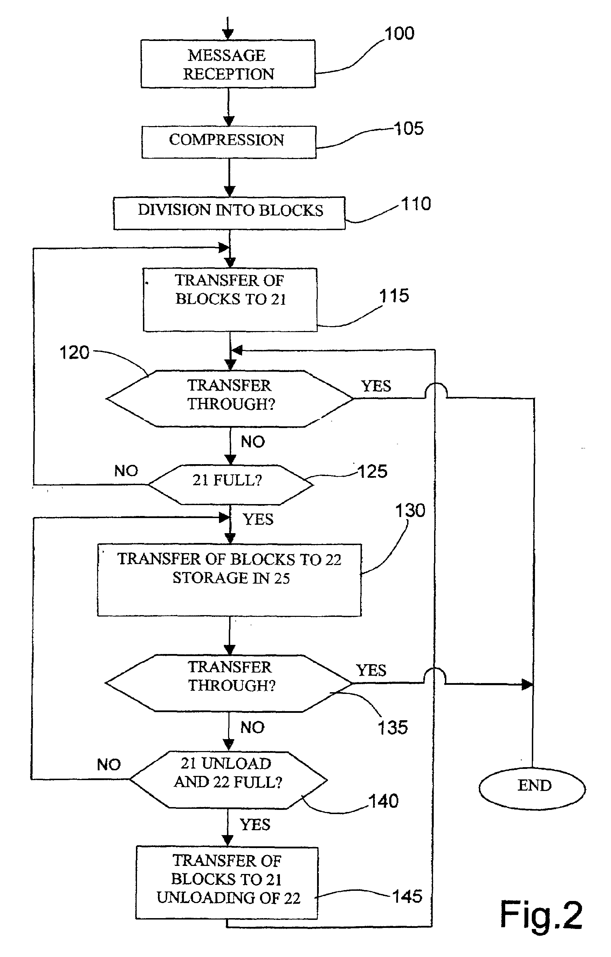

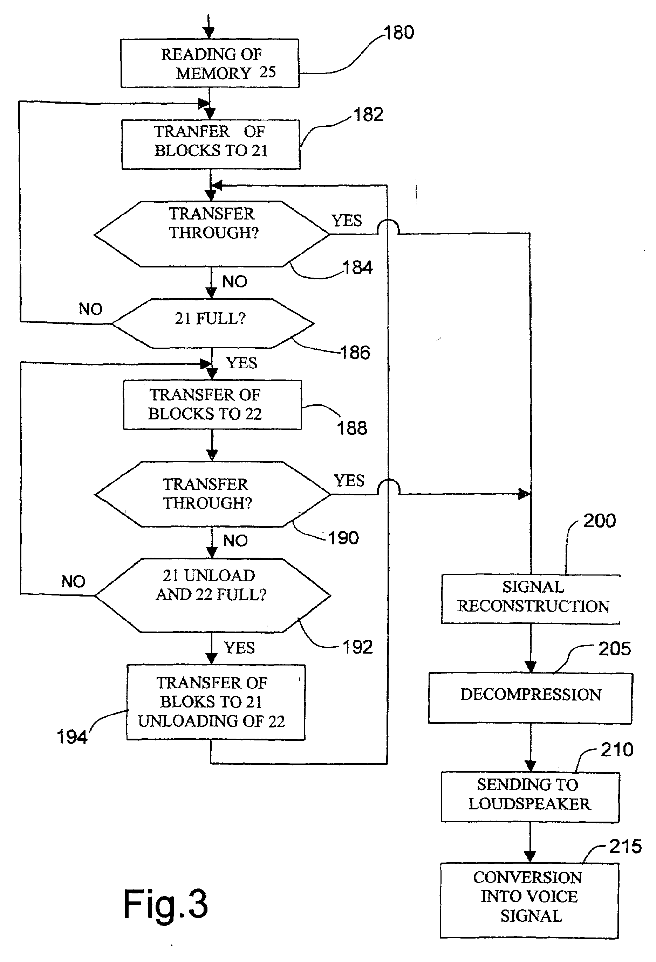

The operation of the electronic device 1 will now be described with reference to Figures 2 and 3.

Initially (Figure 2), the microphone 42 converts the voice messages coming from a user into analog signals and supplies the latter at input to the signal-conversion unit 4 (block 100). The converter circuit 20 compresses the analog signal received to a pre-set compression value via the ADPCM algorithm and generates a stream of digital signals (block 105). Alternatively, the converter circuit 20 may also implement different compression and decompression algorithms, for example CELP, MELP or LPC-10, which are also known in the literature. The compressed stream of digital signals is then divided into successive blocks or packets, of a fixed dimension, for example 1 kB (block 110). In particular, each block of digital signals corresponds to a portion of the original voice message having a duration of 1.024 s if the compression level used is 8 kbps, and a duration of 205 ms if the compression level used is 40 kbps. This block organization of the original voice message makes it possible to erase or re-write portions of the message simply by eliminating or erasing and re-writing the associated blocks.

Next, each block of digital signals is stored in the two RAM buffers 21, 22. In detail, initially the blocks of digital signals are transferred to a first one the two RAM buffers 21, 22, for example to the first RAM buffer 21 (block 115). If data transfer is not completed (output NO from block 120), when the first RAM buffer 21 is full (output NO from block 125) the control unit 3 issues a command for the signal-conversion unit 4 to switch between the first RAM buffer 21 and the second RAM buffer 22, so as to transfer data to the second RAM buffer 22, and at the same time a command to send, to the memory device 25, the blocks stored in the first RAM buffer 21, which is thus unloaded (block 130). If data transfer is not completed (output NO from block 135), when the second RAM buffer 22 is full (output NO from block 140) the control unit 3 issues a command for the signal-conversion unit 4 to switch between the second RAM buffer 22 and the first RAM buffer 21, and to send the blocks stored in the second RAM buffer 22 to the memory device 25 (block 145). The cycle then proceeds in the way described above, returning to block 125 until the transfer of the blocks to the first RAM buffer 21 or to the second RAM buffer 22 terminates (output YES from block 120 or block 135), in which case the RAM buffer 21 or 22 used at that moment sends the remaining data to the memory device 25 (block 150 or block 155).

Storage of the blocks inside the memory device 25 is managed by the control unit 3 according to the list which is stored in the first sub-area 30 and contains the addresses of the free memory locations 28a; in particular, storage may also be non-sequential.

According to the table stored in the second sub-area 31, the control unit 3 may also issue a command for fetching the desired blocks present inside the memory device 25, as is shown in Figure 3. In particular, initially the desired blocks are read by the memory device 25 (block 180) and are sent to the two RAM buffers 21, 22, and then to the converter circuit 20 in a way similar to the one that has just been described. Next, the blocks received by the converter circuit 20 are re-united (block 200), decompressed (block 205), and sent to the loudspeaker 43 (block 210), which, at output from the electronic device 1, reproduces the original voice message (block 215).

The advantages that may be obtained with the electronic device 1 that has been described are illustrated in what follows. In the first place, the electronic device 1 has a greater storage capacity, given the same circuit complexity, and hence the same costs, as compared to the known devices previously described, thanks to integration, on one and the same chip 50, of the converter circuit 20, which carries out digital compression, and of the memory device 25, which is of the non-volatile and multilevel type.

In addition, the use of a non-volatile memory considerably reduces the consumption of the electronic device 1 as compared to the known device of the discrete type, in so far as it can be turned off without there being any loss of the data stored in the memory.

Furthermore, the electronic device 1 of a rather small size, and consequently can be used also in portable applications, such as watches, electronic notebooks, electronic pens, and the like.

In addition, block storage of the voice message inside a non-volatile memory enables use of the electronic device 1 even when the memory degrades and presents a reduced capacity. In this case, in fact, it is sufficient to mark as unusable the blocks corresponding to the faulty memory area, i.e., it is sufficient to reduce the total recording time of the electronic device 1.

Storage of the voice message in chained blocks, moreover, enables the electronic device 1 to edit the voice messages themselves.

Finally, it is clear that numerous variations and modifications may be made to the electronic device described and illustrated herein, all falling within the inventive idea, as defined in the attached claims.

In particular, although the invention has been described with particular reference to the case in which the memory device 25 is implemented by means of a multilevel flash EEPROM, it is equally applicable to other types of non-volatile memories, such as multilevel EPROMs or EEPROMs. In addition, the converter circuit 20 can be made employing any suitable technology.

## Claims

1. An electronic device (1) for the recording/reproduction of voice data, comprising a chip (50) of semiconductor material, characterized in that it comprises:
- a main transmission line (6);
- a control unit (3) integrated in said chip (50) and connected to said main transmission line (6) ;
- a signal-conversion unit (4), integrated in said chip (50) and connected to said main transmission line (6), said signal-conversion unit (4) comprising:
- reception means (20a) receiving an input analog signal correlated to a voice signal;
- compression means (105) compressing said input analog signal and generating a first stream of compressed digital signals;
- fetching means (24) receiving a second stream of compressed digital signals; and
- decompression means (205) decompressing said second stream of compressed digital signals and generating an output analog signal;
- and a non-volatile memory unit (5) integrated in said chip (50) and connected to said main transmission line (6), said non-volatile memory unit (5) storing said first stream of compressed digital data in memory locations (28a), and generating said second stream of compressed digital data according to first control signals generated by said control unit (3).

2. The device according to Claim 1, characterized in that said control unit (3) comprises a microprocessor.

3. The device according to Claim 1, characterized in that said control unit (3) comprises a microcontroller.

4. The device according to any of Claims 1-3, characterized in that said signal-conversion unit (4) comprises:
- a converter circuit (20) connected to said reception means (20a); and
- temporary-storage means (21, 22) which temporarily store said first stream and second stream of compressed digital signals.

5. The device according to Claim 2 or Claim 3,
characterized in that said converter circuit (20) comprises dividing means (110) generating blocks of digital signals having a fixed dimension, each block of digital signals comprising one portion of pre-set duration of said voice signal.

6. The device according to Claim 5, characterized in that said temporary-storage means (21, 22) comprise a first memory buffer (21) and a second memory buffer (22), and in that said signal-conversion unit (4) comprises control means (115-155) controlling transfer of said blocks of digital signals alternately to said first memory buffer (21) and said second memory buffer (22) according to second control signals supplied by said control unit (3).

7. The device according to Claim 6, characterized in that said first and second memory buffers (21, 22) are of the RAM type.

8. The device according to Claim 6 or Claim 7, characterized in that said control means (115-155) comprise:
- means for transferring (115) first blocks of digital signals to said first memory buffer (21);
- first means for detecting filling (125) of said first memory buffer (21);
- first transfer-switching means (130) for transferring second blocks of digital signals to said second memory buffer (22) and for sending said first blocks of digital signals to said non-volatile memory unit (5) ;
- second means for detecting filling (140) of said second memory buffer (22); and
- second transfer-switching means (145) for transferring third blocks of digital signals to said first memory buffer (21) and for sending said second blocks of digital signals to said non-volatile memory unit (5).

9. The device according to any of the foregoing claims, characterized in that said non-volatile memory unit (5) comprises a memory device (25) having:
- a first memory area (28) storing said first stream of digital signals in said memory locations (28a); and
- a second memory area (29) storing information regarding occupation of said memory locations (28a) of said first memory area (28).

10. The device according to Claim 9, characterized in that said second memory area (29) comprises a first sub-area (30) and a second sub-area (31), said first sub-area (30) storing addresses of memory locations (28a) that are free, and said second sub-area (31) storing read-sequence pointers.

11. The device according to Claim 9, characterized in that said memory device (25) comprises a digital flash EEPROM of the multilevel type.

12. A method for the recording/reproduction of voice data, characterized in that it comprises the steps of:
- receiving (100) an input analog signal correlated to a voice signal;
- compressing (105) said input analog signal;
- generating (110) a first stream of compressed digital signals;
- transferring (115) said first stream of compressed digital signals to temporary-storage means (21, 22);
- sending (130) said first stream of compressed digital signals from temporary-storage means (21, 22) to an integrated non-volatile memory unit (5);
- transferring (180) a second stream of compressed digital signals from said integrated non-volatile memory unit (5) to said temporary-storage means (21, 22);
- sending said second stream of compressed digital signals to a converter circuit (200);
- decompressing (205) said second stream of compressed digital signals; and
- generating (215) an output analog signal.

13. The method according to Claim 12, characterized in that said step of generating (110) a first stream of compressed digital signals comprises the step of dividing a compressed input analog signal into blocks of digital signals having a fixed dimension, each block of digital signals comprising one portion of pre-set duration of said voice signal.

14. The method according to Claim 13, characterized in that said step of transferring (115) said first stream of compressed digital signals to temporary-storage means (21, 22) comprises the steps of:
- transferring (115) first blocks of digital signals to a first memory buffer (21);
- detecting a condition of filling (125) of said first memory buffer (21);
- transferring second blocks of digital signals to a second memory buffer (22), and sending said first blocks of digital signals to said integrated non-volatile memory unit (5);
- detecting a condition of filling (140) of said second memory buffer (22); and
- transferring third blocks of digital signals to said first memory buffer (21), and sending said second blocks of digital signals to said non-volatile memory unit (5).
